**Europäisches Patentamt**

**European Patent Office**

**Office européen des brevets**

(19)

(11) Veröffentlichungsnummer: **0 155 483**
A2

# EUROPÄISCHE PATENTANMELDUNG

(12)

(21) Anmeldenummer: **85101265.8**

(22) Anmeldetag: **07.02.85**

(51) Int. Cl.⁴: **H 03 H 7/38**
//G01S15/89, G10K15/00,
H04R17/00

(30) Priorität: **17.03.84 DE 3409927**

(43) Veröffentlichungstag der Anmeldung:
**25.09.85** Patentblatt **85/39**

(84) Benannte Vertragsstaaten:
**CH DE FR GB LI NL**

(71) Anmelder: **ERNST LEITZ WETZLAR GMBH**
**Ernst-Leitz-Strasse 30 Postfach 20 20**
**D-6330 Wetzlar 1(DE)**

(72) Erfinder: **Atalar, Abdullah, Dr. Ing.**
**Bahcelievler, 5. Sok. 47/4**
**Ankara(TR)**

(54) **Breitbandiges Anpassungsnetzwerk.**

(57) Breitbandiges Netzwerk zur Anpassung einer signalführenden Leitung mit einem Wellenwiderstand von 50 Ω an einen piezoelektrischen Übertrager mit einer Kapazität $C_o$ und einer Reaktanz $X_o$ für eine Mittenfrequenz $f_o$ des zu übertragenden Frequenzbandes. In Abhängigkeit von der Reaktanz $X_o$ werden unterschiedliche Schaltungsanordnungen und Dimensionierungsvorschriften für die Schaltungselemente angegeben. Der Übertrager ist Teil einer akustischen Linsenanordnung.

Fig. 2

Fig. 3

Fig. 4

## Breitbandiges Anpassungsnetzwerk

Die Erfindung betrifft ein breitbandiges Netzwerk zur Anpassung einer signalführenden Leitung mit einem Wellenwiderstand von 50 $\Omega$ an einen piezoelektrischen Übertrager mit einer Kapazität $C_o$ und einer Reaktanz $X_o$ für eine Mittenfrequenz $f_o$ des zu übertragenden Frequenzbandes.

Piezoelektrische Übertrager dieser Art werden insbesondere in der akustischen Mikroskopie zur Umwandlung hochfrequenter Schwingungen in Ultraschallwellen und umgekehrt verwendet. Sie werden in direktem akustischen Kontakt auf einem Schallausbreitungsmedium, z.B. Saphir, angebracht. Üblicherweise bestehen sie aus einer gesputterten Zinkoxid-Schicht (ZnO), die zwischen zwei Metallschichten eingebettet ist, von denen die eine auf den Saphir aufgesputtert ist. Wenn dann ein elektrisches Feld einer geeigneten Frequenz zwischen den Metallschichten aufgebaut wird, erzeugt die ZnO-Schicht ein akustisches Feld. Die Schichtdicke muß entsprechend der gewünschten Arbeitsfrequenz für die akustische Mikroskopie ausgewählt werden. Typische Arbeitsfrequenzen liegen zwischen 100 MHz und 2 GHz. Die Dicke der ZnO-Schicht wird zu $\lambda/4$ bis $\lambda/2$ der Wellenlänge

0155483

bei der Arbeitsfrequenz innerhalb der ZnO-Schicht gewählt.

Für den elektrischen Anschluß stellt ein solcher Übertrager im wesentlichen eine kapazitive Impedanz dar.
Ihr Ersatzschaltbild kann als Widerstand in Serie mit
einer Kapazität dargestellt werden. Typische Werte
für den Widerstand liegen bei 1/10 der Reaktanz des
Kondensators in der Mitte des zu übertragenden Frequenzbandes, wenn der Q-Faktor des Übertragers 10 beträgt, wobei der Gütefaktor Q als Verhältnis der Eingangsleistung zur Ausgangsleistung definiert ist.

Eine direkte Kopplung des Übertragers an ein 50 Ω-
System würde wegen der großen elektrischen Fehlanpassung starke Leistungsverluste mit sich bringen. Man
benutzt aus diesem Grunde elektrische Anpassungsnetzwerke zwischen dem Übertrager und dem 50 Ω-System,
die üblicherweise für eine bestimmte Arbeitsfrequenz
optimiert werden, so daß die Anpassung nur für einen
schmalen Bereich um diese Frequenz herum gegeben ist.
Die Anpassungsnetzwerke haben daher nur eine begrenzte
Bandbreite.

Für Anwendungen über einen großen Bandbreitenbereich
versucht man, das Anpassungsnetzwerk für einen größeren Bereich zu optimieren. Dies gelingt im allgemeinen
nur in dem Maße, in dem auch die Anzahl der Anpassungselemente erhöht wird. Eine theoretische obere Grenze
für die Erweiterung der Bandbreite wird im wesentli-

0155483

chen durch den Q-Faktor des Übertragers bestimmt.

In dem Maße, in dem sich die Anzahl der Bauelemente erhöht, wird die praktische Realisierungsmöglichkeit für das Netzwerk mehr und mehr erschwert. Man ist daher aus praktischen Gründen bemüht, die Anzahl der Anpassungselemente zu begrenzen.

Für die Anwendung im Bereich der akustischen Mikroskopie ist weiterhin zu beachten, daß das Anpassungsnetzwerk notwendigerweise ein Teil der akustischen Linsenanordnung ist. Diese Linse muß zur Bildabtastung in einem Schwingsystem bewegt werden. Es besteht daher auch aus energetischen Gründen ein Bedürfnis zur Miniaturisierung des Anpassungsnetzwerkes, um die zu bewegenden Massen so gering wie möglich halten zu können.

Der Erfindung lag daher die Aufgabe zugrunde, Konfigurationen für das Anpassungsnetzwerk anzugeben, die mit einer minimalen Anzahl von Bauelementen ein Maximum an Bandbreite erreichen. Für einen ZnO-Übertrager sollte insbesondere eine Bandbreite von $f_o/2$ möglich sein.

Diese Aufgabe wird durch Anpassungsnetzwerke für piezoelektrische Übertrager der eingangs genannten Art erfindungsgemäß dadurch gelöst, daß in Abhängigkeit von der Reaktanz des Übertragers die jeweils in den kennzeichnenden Merkmalen der Ansprüche 1, 4, 7 angegebene Schaltung gewählt wird. Vorteilhafte Dimensionierungen Dem Anpassungsnetzwerk 5 ist ein Zirkulator 6 vorgeschaltet, der während einer ersten Periode das von einen Generator kommende Signal 7 zum Übertrager durchläßt und in einer zweiten Periode dieses Signal sperrt und das vom Übertrager kommende Meßsignal auf die Ausgangsleitungen 8 durchläßt. Die signalführende Leitung ist mit 9 bezeichnet.

Die Kapazität $C_o$ des Übertragers kann aufgrund der bekannten Fläche A, der Dicke d und der Dielektrizitäts-konstanten $\xi$ der piezoelektrischen Schicht 3 bestimmt werden:

$$C_o = \frac{\xi \cdot A}{d}$$

Für eine vorgesehene Mittenfrequenz $f_o$ des zu übertra-genden Frequenzbandes ergibt sich dann die Reaktanz $X_o$ zu

$$X_o = \frac{1}{2\pi f_o} \cdot \frac{1}{C_o}$$

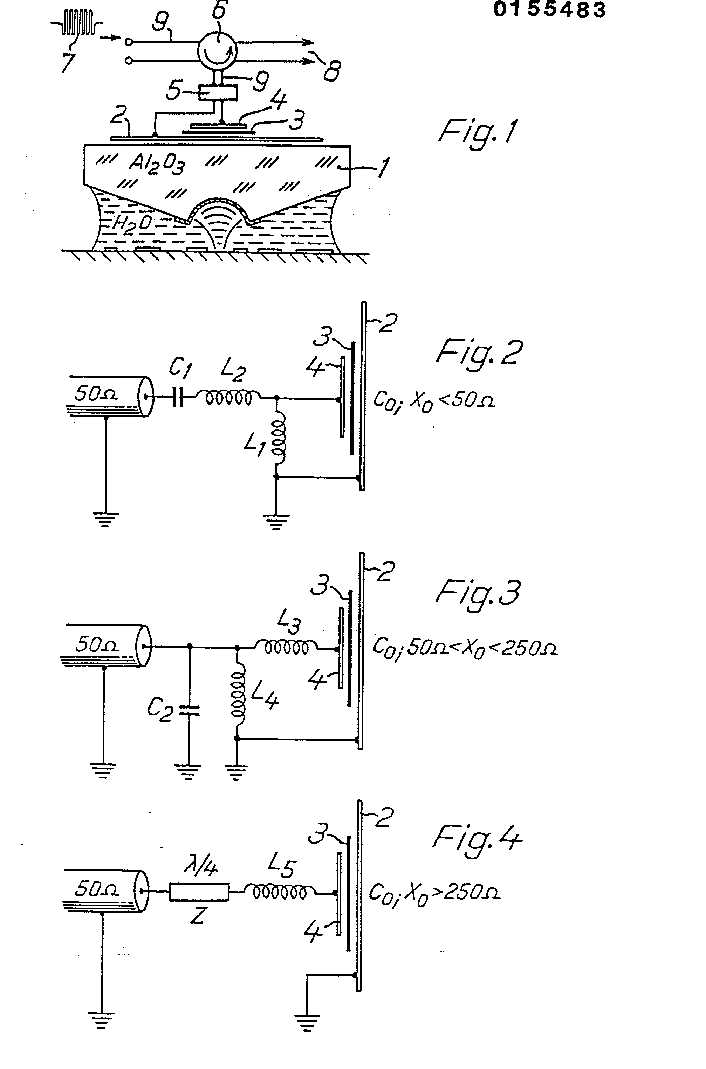

Das in Fig. 2 dargestellte Anpassungsnetzwerk ist bei einer Übertrager-Reaktanz $X_o < 50\,\Omega$ besonders geeignet. Die Schaltungselemente $L_1$, $C_1$ und $L_2$ haben dabei folgen-de, näherungsweise geltenden Werte:

$$L_1 \simeq \frac{1}{(2\pi f_o)^2} \cdot \frac{1}{C_o} \quad ; \quad C_1 \simeq \frac{1}{5} \cdot C_o ; \quad L_2 \simeq \frac{1}{(2\pi f_o)^2} \cdot \frac{1}{C_1}$$

Bei Frequenzen im GHz-Bereich kann dieses Netzwerk dadurch realisiert werden, daß mit der aktiven Elektrode 4 des Übertragers zwei Anschlußdrähte verbunden werden. Einer dieser Drähte wird mit der Masse verbunden, um die Induktivität $L_1$ zu bilden und der andere wird mit einem Chip-Kondensator $C_1$ verbunden, um die Induktivi-

für die Bauelemente der Anpassungsnetzwerke ergeben sich aus den Ansprüchen 2, 5, 6. Die sich danach ergebenden Werte lassen sich bei Frequenzen $f_o$ im Giga-Hertz-Bereich in besonders vorteilhafter Weise durch die in den Ansprüchen 3, 6 angegebenen Maßnahmen realisieren.

Ersatzschaltbilder der erfindungsgemäßen Anpassungsnetzwerke sind in der Zeichnung dargestellt und werden nachfolgend beschrieben. Im einzelnen zeigen:

Fig. 1    eine an sich bekannte akustische Linsenanordnung,

Fig. 2    das Ersatzschaltbild für die Anpassung an einen Übertrager mit einer Reaktanz $X_o < 50 \Omega$,

Fig. 3    das Ersatzschaltbild bei einer Reaktanz $50 \Omega < X_o < 250 \Omega$,

Fig. 4    das Ersatzschaltbild bei einer Reaktanz $X_o > 250 \Omega$.

Fig. 1 zeigt eine akustische Linsenanordnung, wie sie in der akustischen Reflektionsmikroskopie verwendet wird. Auf einer ebenen Fläche eines Saphirstabes 1 ist ein piezoelektrischer Übertrager angebracht, der aus einer ersten Goldschicht 2, einer darauf gesputterten ZnO-Schicht 3 und einer zweiten Goldschicht 4 besteht. Die beiden Goldschichten 2 und 4 sind mit dem Anpassungsnetzwerk 5 verbunden. Dabei ist die Goldschicht 4 die aktive Elektrode des Übertragers. Die Goldschicht 2 liegt am Massepotential.

tät $L_2$ zu bilden. Bei einer Mittenfrequenz $f_o = $ 1 GHz kann dieses Anpassungsnetzwerk für einen Frequenzbereich von etwa 750 MHz bis 1250 MHz benutzt werden. Das ist ein für die akustische Mikroskopie bevorzugter Bereich. Bei Verwendung von Übertragern mit einer Reaktanz $X_o < 50\,\Omega$ können somit akustische Linsenanordnungen konstruiert werden, deren geometrische Abmessungen nur noch von mechanischen Fassungsteilen und elektrischen Verbindungselementen bestimmt werden.

Das in Fig. 3 dargestellte Anpassungsnetzwerk ist für einen Reaktanz-Bereich von 50-250 $\Omega$ besonders vorteilhaft. Die Schaltungselemente $L_3$, $C_2$ und $L_4$ haben dabei folgende, näherungsweise geltenden Werte:

$$L_3 \simeq \frac{1}{(2\pi f_o)^2} \cdot \frac{1}{C_o} \; ; \quad C_2 \simeq 5 \cdot C_o \; ; \quad L_4 \simeq \frac{1}{(2\pi f_o)^2} \cdot \frac{1}{C_2}$$

Auch hier ergibt sich für Frequenzen im GHz-Bereich eine Realisierungsmöglichkeit, die den geometrischen Aufbau des Anpassungsnetzwerkes wesentlich vereinfacht. $L_3$ kann nämlich durch geeigneten Abgleich der Länge des Anschlußdrahtes zur aktiven Elektrode 4 des Übertragers verwirklicht werden.

Das in Fig. 4 dargestellte Anpassungsnetzwerk für Übertrager-Reaktanzen $X_o > 250\,\Omega$ benutzt Schaltungselemente, die folgende näherungsweise geltenden Werte besitzen:

$$L_5 \simeq \frac{1}{(2\pi f_o)^2} \cdot \frac{1}{C_o} \; ; \quad z \simeq \frac{1}{5} \cdot X_o$$

Die geometrischen Abmessungen dieses Netzwerkes werden im wesentlichen durch die notwendige Impedanz Z bestimmt,

0155483

die üblicherweise durch einen Schichtwellenleiter gebildet wird, dessen Länge einem Viertel der Wellenlänge $\lambda$ bei der Mittenfrequenz $f_o$ beträgt.

<u>A n s p r ü c h e</u>

1. Breitbandiges Netzwerk zur Anpassung einer signalführenden Leitung mit einem Wellenwiderstand von
50 $\Omega$ an einen piezoelektrischen Übertrager mit einer Kapazität $C_o$ und einer Reaktanz $X_o$ für eine Mittenfrequenz $f_o$ des zu übertragenden Frequenzbandes,
d a d u r c h   g e k e n n z e i c h n e t ,   daß
bei einer Reaktanz $X_o < 50 \Omega$ der Ausgang der signalführenden Leitung (9) über eine Reihenschaltung aus
einer Kapazität $C_1$ und einer Induktivität $L_2$ mit
der aktiven Elektrode (4) des Übertragers (2,3,4)
verbunden ist und diese zusätzlich über eine Induktivität $L_1$ am Massepotential liegt.

2. Breitbandiges Netzwerk nach Anspruch 1,
d a d u r c h   g e k e n n z e i c h n e t ,   daß
zumindest näherungsweise folgende Elementwerte eingehalten sind:

$$L_1 \cong \frac{1}{(2\pi f_o)^2} \frac{1}{C_o} \quad ; \quad C_1 \cong \frac{1}{5} \cdot C_o$$

$$L_2 \cong \frac{1}{(2\pi f_o)^2} \cdot \frac{1}{C_1}$$

3. Breitbandiges Netzwerk nach Anspruch 2, d a d u r c h g e k e n n z e i c h n e t , daß für Frequenzen $f_o$ im GHz-Bereich die Induktivitäten $L_1$ und $L_2$ durch zwei mit der aktiven Elektrode (4) des Übertragers verbundene Anschlußdrähte und die Kapazität $C_1$ durch einen Chip-Kondensator gebildet sind.

4. Breitbandiges Netzwerk nach dem Oberbegriff des Anspruchs 1, d a d u r c h g e k e n n z e i c h - n e t , daß bei einer Reaktanz 50 $\Omega < X_o < 250 \,\Omega$ der Ausgang der signalführenden Leitung (9) über eine Induktivität $L_3$ mit der aktiven Elektrode (4) des Übertragers und über eine Parallelschaltung aus einer Kapazität $C_2$ und einer Induktivität $L_4$ mit dem Massepotential verbunden ist.

5. Breitbandiges Netzwerk nach Anspruch 4, d a d u r c h g e k e n n z e i c h n e t , daß zumindest näherungsweise folgende Elementwerte eingehalten sind:

$$L_3 \cong \frac{1}{(2\pi f_o)^2} \cdot \frac{1}{C_o} \quad ; \quad C_2 \cong 5 \cdot C_o$$

$$L_4 \;\approx\; \frac{1}{(2\pi f_o)^2} \cdot \frac{1}{C_2}$$

6. Breitbandiges Netzwerk nach Anspruch 5, d a d u r c h   g e k e n n z e i c h n e t , daß für Frequenzen $f_o$ im GHz-Bereich die Induktivität $L_3$ durch den in der Länge entsprechend abgeglichenen Anschlußdraht zur aktiven Elektrode (4) des Übertragers gebildet wird.

7. Breitbandiges Netzwerk nach dem Oberbegriff des Anspruchs 1, d a d u r c h   g e k e n n z e i c h n e t , daß bei einer Reaktanz $X_o > 250\ \Omega$ der Ausgang der signalführenden Leitung (9) über eine Reihenschaltung aus einer Impedanz Z und einer Induktivität $L_5$ mit der aktiven Elektrode (4) des Übertragers verbunden ist.

8. Breitbandiges Netzwerk nach Anspruch 7, d a d u r c h   g e k e n n z e i c h n e t , daß zumindest näherungsweise folgende Elementwerte eingehalten sind:

$$L_5 \;\approx\; \frac{1}{(2\pi f_o)^2} \cdot \frac{1}{C_o} \;\; ; \;\; Z \approx \frac{1}{5} X_o$$

M 07

0155483

Fig.1

Fig.2

$C_0; X_0 < 50\Omega$

Fig.3

$C_0; 50\Omega < X_0 < 250\Omega$

Fig.4

$C_0; X_0 > 250\Omega$